Europäisches Patentamt

European Patent Office

Office européen des brevets

(19)

(11) Veröffentlichungsnummer: **0 168 510**
**B1**

(12) **EUROPÄISCHE PATENTSCHRIFT**

(45) Veröffentlichungstag der Patentschrift:
18.01.89

(51) Int. Cl.⁴: **G 03 F 1/00**

(21) Anmeldenummer: **84108325.6**

(22) Anmeldetag: **16.07.84**

(54) Verfahren zur Reparatur von Transmissionsmasken.

(43) Veröffentlichungstag der Anmeldung:
**22.01.86 Patentblatt 86/4**

(45) Bekanntmachung des Hinweises auf die Patenterteilung:
**18.01.89 Patentblatt 89/3**

(84) Benannte Vertragsstaaten:
**DE FR GB**

(56) Entgegenhaltungen:
**APPLIED PHYSICS LETTERS, Band 29, Nr. 9, 1. November 1976, Seiten 596-598, American Institute of Physics, US; A.N. BROERS u.a.: "Electron-beam fabrication of 80-A metal structures"**

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB**

(72) Erfinder: **Behringer, U., Dr. Dipl.-Phys, Wolfsbergstrasse 27, D-7403 Ammerbuch 4 (DE)**
Erfinder: **Bohlen, H., Dipl.-Phys., Hohenzollernring 46, D-7403 Ammerbuch (DE)**
Erfinder: **Vettiger, P., Dipl.-Ing., Langmoosstrasse 33, CH-81365 Langnau/a. A. (CH)**
Erfinder: **Zapka, W., Dr. Dipl.-Phys., Ritterstrasse 29, D-7031 Gärtringen-Rohrau (DE)**

(74) Vertreter: **Kreidler, Eva-Maria, Dr. rer. nat., Schönaicher Strasse 220, D-7030 Böblingen (DE)**

**Beschreibung**

Die Erfindung betrifft ein Verfahren zum Reparieren von Transmissionsmasken für die Röntgenstrahl-, Elektronenstrahl- bzw. Ionenstrahllithographie unter Anwendung von Kontaminationspolymerisation.

Der in der VLSI-Halbleitertechnologie anhaltende Trend zur Reduzierung der Schaltkreisdimensionen macht Lithographieverfahren und Belichtungssysteme erforderlich, die das Drucken von Mustern mit Dimensionen im Submikrometerbereich gestatten. Mit den bisher verwendeten lichtoptischen Belichtungssystemen können diese Muster mit den gewünschten Submikrometerdimensionen wegen der geringen Fokussierungstiefe und der Streuung des Lichts an den Kanten der Masken nicht mehr hergestellt werden. Es ist deshalb erforderlich, zu Verfahren überzugehen, bei denen nichtoptische Strahlungsarten mit viel kürzeren Wellenlängen als die in lichtoptischen Systemen eingesetzten verwendet werden. Als nichtoptische Strahlung werden derzeit Röntgenstrahlen, Elektronenstrahlen oder Ionenstrahlen eingesetzt.

Für die Belichtung mit Röntgenstrahlen, Elektronen- oder Ionenstrahlen müssen Transmissionsmasken mit Submikrometerstrukturen und einer hohen geometrischen Präzision, die für das Übereinanderdrucken erforderlich ist, hergestellt werden. Die Masken für Elektronen- und Ionenstrahllithographie sind, im Gegensatz zu Masken für optische Belichtung, die aus Chromstrukturen auf Glassubstraten aufgebaut sind, aus dünnen Folien oder Membranen aus Silicium oder Siliciumnitrid aufgebaut und weisen in den transparenten Bereichen physikalische Löcher für den Durchlass der Strahlung auf. Ihre Herstellung erfolgt in photolithographischen Prozessen, gefolgt von isotropen und streng anisotropen Ätzprozessen. Während des Herstellungsprozesses kann es dazu kommen, dass durch Staubteilchen oder noch viel häufiger durch eine Lochbildung in dem zu belichtenden Photoresist zusätzliche, unerwünschte Löcher auftreten. Ausserdem können durch Gitterfehler, die während der Bordotierung des Wafers, aus dem die Maske hergestellt wird, auftreten, beim selektiven Ätzprozess zusätzliche Defektlöcher entstehen. Diese Defektlöcher sind unerwünscht, weil sie während des Herstellungsprozesses für die Transmissionsmaske wie die gewünschten Strukturen eingeätzt werden und damit die Maskenstrukturen verfälschen. Selbst bei besten Reinraumbedingungen kann das Auftreten dieser zusätzlichen Löcher nie ganz verhindert werden. Deshalb wurden Verfahren entwickelt, um Transmissionsmasken zu reparieren.

Das in der lichtoptischen Lithographie verwendete Maskenreparaturverfahren, bei dem mit Hilfe eines Laserstrahls der Chromüberschuss an Maskenstrukturen weggenommen wird, bzw. Defektlöcher durch Aufpinseln von Photoresist per Hand geschlossen werden, kann zur Reparatur der betrachteten Transmissionsmasken nicht verwendet werden, weil die Reparatur nicht wie bei lichtoptischen Masken an Vorlagen mit zehnfacher Vergrösserung, sondern an Transmissionsmasken, die alle Strukturen im Massstab 1:1 enthalten, vorgenommen wird, wobei die Strukturen oft kleiner als 0,5 µm ausfallen.

Es wurde bereits ein Verfahren zur Reparatur fehlerhafter Transmissionsmasken vorgeschlagen, bei dem auf die Oberseite der fehlerhaften Maske eine Photoresistschicht aufgetragen und alle Maskenlöcher, einschliesslich der fehlerhaften, geschlossen werden. Anschliessend wird die Photoresistschicht durch eine Transmissionsmaske, deren Struktur identisch mit der Struktur der zu reparierenden Maske ist, belichtet. Hierbei muss darauf geachtet werden, dass in der zur Belichtung verwendeten Maske etwa vorhandene Defektlöcher nicht an denselben Stellen wie bei der zu reparierenden Maske auftreten. Weitere Fehler, die durch Defektstellen in der zur Reparatur verwendeten Maske bedingt sind, können dadurch ausgeschaltet werden, dass die Photoresistschicht auf der zu reparierenden Maske noch einmal durch eine strukturgleiche Maske belichtet wird, wobei wiederum die Defektlöcher dieser Maske nicht mit den Defektlöchern in der zuvor benutzten Maske und der zu reparierenden Maske zusammenfallen dürfen. Dieses Verfahren hat den Nachteil, dass der auf der zu reparierenden Maske verbleibende Photoresist bei der späteren Belichtung der Maske zu Aufladungen führen kann, was unerwünscht ist. Ausserdem ist die Anwendung dieses Reparaturverfahrens nur dann sinnvoll, wenn eine Inspektion der zu reparierenden Maske ergibt, dass viele Defektlöcher zu schliessen sind. Wenn, als Folge sehr guter Reinraumbedingungen, eine visuelle Inspektion der Masken ergibt, dass nur wenige Defektlöcher zu schliessen sind, ist ein Verfahren vorteilhafter, mit dem einzelne Defektlöcher repariert werden können.

Es ist auch bekannt (Appl. Phys. Lett., Vol. 29, No. 9, Nov. 1, 1976, Broers et al), dass mit einem Elektronenstrahl ein Kontaminationsresistmuster auf einem Gold-Palladiumfilm, welcher auf einer Kohlenstoffolie angeordnet ist, erzeugt werden kann. Das Resistmuster wird dann zum Ätzen des Metallfilms verwendet. In dieser Veröffentlichung ist weder die Herstellung selbsttragender Kontaminationsfäden beschrieben, noch angegeben, dass dieses Verfahren zur Reparatur von Transmissionsmasken verwendet werden kann.

Aufgabe der Erfindung ist daher, ein Verfahren zur Reparatur einzelner Defektlöcher in Transmissionsmasken anzugeben, das, weil in bereits vorhandenen Apparaturen durchführbar, sehr kostengünstig ist und die zuvor beschriebenen Nachteile nicht aufweist.

Die Aufgabe der Erfindung wird gelöst durch ein Verfahren gemäss Patentanspruch 1.

Vorteilhafte Ausführungsformen der Erfindung sind in den abhängigen Ansprüchen niedergelegt.

Bei dem erfindungsgemässen Reparaturverfahren wird ausgenutzt, dass bei Bestrahlung einer im Vakuum befindlichen Fläche eines Rasterelektronenmikroskops mit einem Elektronenstrahl im Auftreffpunkt des Strahls eine Kohlenwasserstof-

Polymerisatschicht aufwächst. Dieser Effekt ist Elektronenmikroskopikern seit vielen Jahren bekannt und wird als Kontamination bezeichnet. Es wurde auch der Mechanismus der Elektronenstrahlpolymerisation von Kohlenwasserstoffmolekülen, welche am Substrat adsorbiert sind, untersucht und festgestellt, dass das Wachsen der adsorbierten Schicht aus der Dampfphase erfolgte und dass wesentliche Quellen für die Kohlenwasserstoffmoleküle Diffusionspumpenöl, Gummidichtungen oder fettige Oberflächen waren. R.F.W. Pease und W.C. Nixon, in 1st Int. Conf. on Electron and Ion Beam Sci. and Tech. 1965, Seiten 220 bis 230, zeigten, dass sich im Weg eines Elektronenstrahls, wenn dieser auf eine Gitterkante fokussiert und langsam von ihr weggeführt wurde, ein selbsttragender Kontaminationsfaden bildete. Der aus der Elektronenmikroskopie bekannte Kontaminationseffekt, der dort als störend empfunden wird, wird erfindungsgemäss zur Reparatur von Transmissionsmasken eingesetzt. In der zuvor abgehandelten Literaturstelle ist diese Anwendung nicht beschrieben.

Die Erfindung wird anhand der speziellen Beschreibung und der Figuren 1 bis 6 näher erläutert.

Es stellen dar:

Fig. 1 einen Querschnitt durch eine Elektronenstrahl-Transmissionsmaske;

Fign. 2A bis 2F ein Verfahren zur Herstellung einer Transmissionsmaske;

Fig. 3 ein zu schliessendes Loch in einer Maske mit zwei geschriebenen Brücken;

Fig. 4A eine Maske mit einem Defektloch neben einer gewünschten Maskenöffnung;

Fig. 4B eine Vergrösserung des Defektlochs von Fig. 4A;

Fign. 5A und 5B ein Defektloch mit mehreren geschriebenen Brücken;

Fig. 6A entspricht Fig. 4A;

Fig. 6B ein repariertes Defektloch neben einer Maskenöffnung gemäss Fig. 6A.

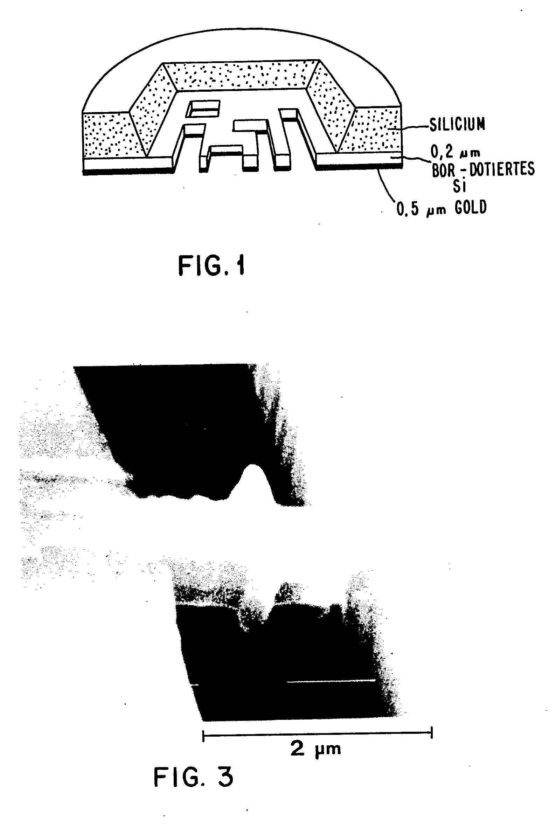

Die in Fig. 1 gezeigte Elektronenstrahl-Transmissionsmaske besteht aus einer einkristallinen Bor-dotierten Siliciummembran von etwa $2\,\mu m$ Dicke und einer Goldschicht auf ihrer Oberfläche, welche die strahlstoppenden Eigenschaften verbessert. Die Maske besitzt die Grösse eines Siliciumwafers und enthält als feinste Strukturen Strukturen von $0{,}3\,\mu m$ Breite. Der gleiche Maskentyp kann auch für Ionenstrahl- oder Röntgenstrahllithographie verwendet werden.

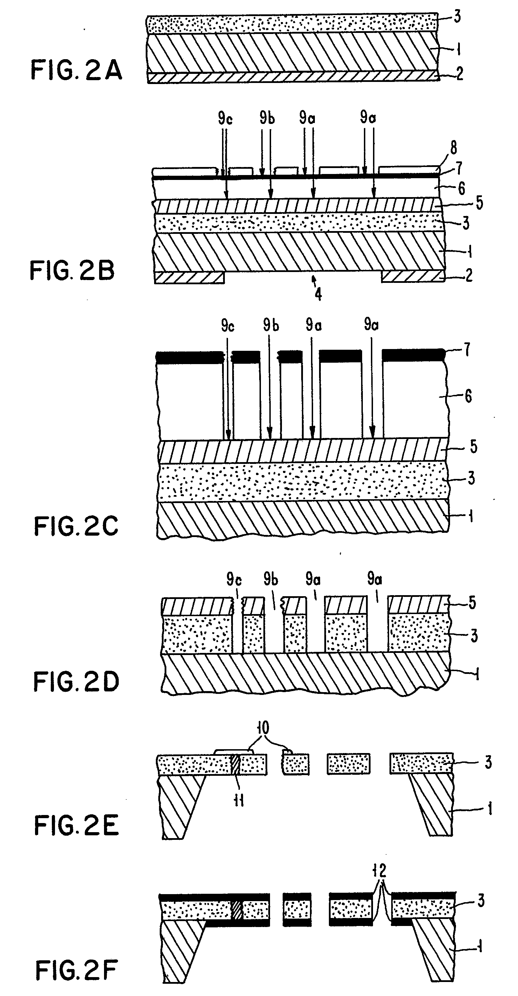

Anhand der Fign. 2A bis 2F wird ein Verfahren zur Herstellung einer Maske für die Elektronenstrahl-, Ionenstrahl- oder Röntgenstrahllithographie beschrieben, bei dem Fehlstellen in der Maske auftreten können, die nach dem erfindungsgemässen Verfahren repariert werden. Als Maskensubstrat wird gemäss Fig. 2A ein 0,2 bis 0,4 mm dicker Siliciumwafer mit einer 100-Orientierung, der auf beiden Seiten poliert ist, verwendet. Die Rückseite des Wafers ist mit einer 0,5 bis 1 $\mu m$ dicken Siliciumdioxidschicht 2 bedeckt. Von der Vorderseite des Siliciumwafers wird Bor in das Substrat eindiffundiert bis zu einer Oberflächenkonzentration von wenigstens $10^{20}$ Boratomen/cm$^3$ (Schicht 3 in Fig. 2A). Die Bordiffusion dient als Ätzbarriere bei einem späteren Ätzen des Siliciumwafers und bestimmt dadurch die Maskenschichtdicke. Weiterhin bewirkt die Borkonzentration eine Zugspannung in der fertigen Maske, die ein Durchbiegen der Maske verhindert, wenn diese in ihrem starren kalten Siliciumrahmen erwärmt wird. Im nächsten Prozessschritt (Fig. 2B) werden mehrere Fenster 4 von Chipgrösse auf der Rückseite durch konventionelle Photolithographie und Nassätzen hergestellt. Durch diese Fenster wird später das Ätzen des Wafers vorgenommen. Auf die bordotierte Vorderseite des Wafers wird dann eine 0,4 bis 0,8 $\mu m$ dicke Siliciumdioxidschicht 5 aufgesputtert. Die Dicke der Siliciumdioxidschicht hängt von dem Ätzratenverhältnis von Siliciumdioxid zu Silicium im reaktiven Ionenätzprozess zur Übertragung des Musters in das Silicium ab. In dem hier beschriebenen Verfahren wird eine Siliciumdioxidschichtdicke von 0,7 $\mu m$ verwendet. Anschliessend kann für Siliciumdioxidschichtdicken unter 0,5 $\mu m$ auf die Siliciumdioxidschicht 5 eine einzige Photoresistschicht in einer Schichtdicke von 0,2 bis 0,5 $\mu m$ aufgetragen werden (nicht dargestellt). In Fig. 2B ist der für grössere Siliciumdioxidschichtdicken angewendete Dreilagen-Resistprozess schematisch dargestellt. Dabei wird auf die Siliciumdioxidschicht 5 eine dicke Photoresistschicht 6 in einer Schichtdicke von 1 bis 2 $\mu m$, vorzugsweise von 1,6 $\mu m$ aufgesponnen. Als Photoresist wurde ein Positiv-Photoresist AZ 1350J der Firma Shipley, welcher aus einem Phenol-Formaldehyd-Harz und 3,4-Dihydroxybenzophenon-4-[naphthochinon-(1,2)diazid-(2)]-sulfonat als reaktivem Bestandteil besteht, aufgesponnen. Der Resist wird dann bei etwa 210 °C 30 Minuten lang gehärtet. Auf die dicke Photoresistschicht 6 wird eine etwa 0,1 bis 0,2 $\mu m$ dicke Siliciumnitridschicht 7 durch Plasmaabscheidung aufgetragen. Diese wiederum wird mit einer 0,3 bis 0,5 $\mu m$ dicken hochempfindlichen Resistschicht 8 bedeckt. Durch Belichten und Entwikkeln wird in dieser Resistschicht das gewünschte Maskenmuster erzeugt. Für Muster mit Dimensionen im Submikrometerbereich wird diese Belichtung mit einem Elektronenstrahlschreiber (vector scan) durchgeführt. Um eine vertikale Resistmaske zu erhalten, werden die entwickelten Strukturen (9a bis 9c) der Schicht 8 durch reaktives Ionenätzen mit CF$_4$ bei einem Fluss von etwa 30 cm$^3$/Min., einem Druck von 67 $\mu$bar und einer Energiedichte von 0,2 Watt/cm$^2$ in die Siliciumnitridschicht 7 übertragen. Die strukturierte Siliciumnitridschicht 7 ist eine ausgezeichnete Maske für das reaktive Ionenätzen der dicken Resistschicht 6 in einer Sauerstoffatmosphäre und bewirkt gleichzeitig eine Verbesserung der Haftung des hochempfindlichen Resists 8 auf der Oberfläche. Das Muster in der Siliciumnitridschicht 7 wird in die darunterliegende Photoresistschicht 6 übertragen durch reaktives Ionenätzen mit Sauerstoff bei einem Fluss von etwa 27 cm$^3$/Min., einem Druck von 2,6 $\mu$bar und einer Energiedichte von 0,2 Watt/cm$^2$. Die unterste Photoresistschicht 6 des Dreilagen-Prozesses dient als Maske zum Ätzen der Siliciumdioxidschicht 5 (Fig. 2C). Das reaktive Ionenätzen erfolgt in einem Reaktor mit Dioden, wobei die Wafer auf einer an Betriebsspannung angelegten Elektrode angeordnet sind. Die Strukturierung der Siliciumdioxidschicht erfolgt durch reaktives Ionenätzen mit $CF_4$ bei einem Fluss von 30 $cm^3$/Min., einem Druck von 67 µbar und einer Energiedichte von 0,15 Watt/$cm^2$. Nach dem Strippen des restlichen Resists 6 wird die strukturierte Siliciumdioxidschicht 5 (Fig. 2D) in einem zweiten reaktiven Ionenätzprozess als Maske verwendet, um ein Muster 10 von etwa 2 bis 4 µm Tiefe in das bordotierte Silicium 3 zu ätzen. In diesem Verfahrensschritt wird ein $SF_6$, $Cl_2$ und Helium-Gemisch mit 5,3 Vol.% $Cl_2$, 2,6 Vol.% $SF_6$, Rest Helium mit einem Fluss von 40 $cm^3$/Min., einem Druck von 53 µbar und einer Energiedichte von etwa 0,2 Watt/$cm^2$ verwendet. Es werden hierbei Ätzratenverhältnisse zwischen Siliciumdioxid und Silicium von 1:5 bis etwa 1:20, vorzugsweise von 1:14, erhalten. Durch das streng gerichtete Ätzen werden nahezu vertikale Siliciumseitenwände (Fig. 2D) erhalten. Zum Ätzen von Silicium sind auch andere Gase, beispielsweise Gasmischungen mit einem Gehalt an Chlor und Argon oder $CCl_2F_2$ und $O_2$ oder $SiF_4$, $Cl_2$, Helium oder Argon geeignet.

Schliesslich wird das Wafersubstrat durch die Öffnungen 4 in der Siliciumdioxidschicht 2 auf der Rückseite des Wafers in einem Nassätzprozess gerichtet geätzt. Die Ätzlösung besteht aus Äthylendiamin, Brenzkatechin, Pyrazin und Wasser. Das Ätzen hört auf bei einer Borkonzentration von $7 \times 10^{19}$ Boratomen/$cm^3$. Die resultierende Maske aus der einkristallinen, bordotierten Membran ist etwa 2 µm dick, in Abhängigkeit von der angewendeten Bordiffusion. Nach dem Entfernen der restlichen Siliciumdioxidschichten 2 wird die strukturierte Siliciummembran mit einer 0,2 bis 0,8 µm dicken Goldschicht 12 (Fig. 2F) belegt. Diese ist erforderlich, um einen Elektronenstrahl bis zu Energien von etwa 25 keV abzubremsen. Die Goldschicht kann entweder durch Aufdampfen oder Aufsputtern aufgebracht werden. Wenn Gold aufgesputtert wird, nehmen die Dimensionen der Maske geringfügig ab.

Nachfolgend wird, ebenfalls anhand der Fign. 2B bis 2F, sowie der Fign. 3 bis 6 das erfindungsgemässe Reparaturverfahren beschrieben. Wird bei der Inspektion einer Transmissionsmaske ein unerwünschtes Loch festgestellt, so ist dies darauf zurückzuführen, dass in der obersten Photoresistschicht 8 (Fig. 2B) neben erwünschten Maskenöffnungen 9a auch ausgefranste Maskenöffnungen 9b und, beispielsweise durch Staub, unerwünschte Maskenöffnungen 9c gebildet werden können. Die unerwünschten Öffnungen täuschen erwünschte vor und werden während des Herstellungsprozesses für die Transmissionsmasken ebenfalls in die darunterliegenden Schichten eingeätzt, so dass die wahre Maskenstruktur verfälscht wird. Auch durch optimale Reinraumbedingungen kann das Auftreten dieser zusätzlichen Löcher nie ganz verhindert werden. Es war deshalb dringend erforderlich, ein Verfahren zur Reparatur von Transmissionsmasken zu entwickeln.

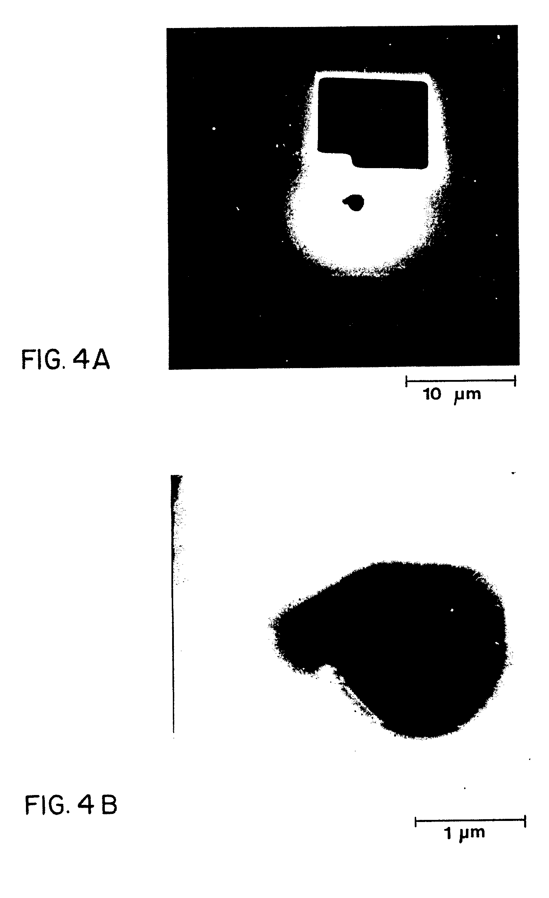

Wird bei der Inspektion einer Transmissionsmaske (Fig. 2D) ein unerwünschtes Loch 9c oder ein ausgefranstes Loch 9b festgestellt, dann muss dieses geschlossen bzw. das ausgefranste Loch korrigiert werden. Hierzu wird die Transmissionsmaske in ein normales handelsübliches Elektronenrastermikroskop anstelle einer Probe eingebracht. Die zu reparierende Maske kann dann wie eine normale Probe im Elektronenrastermikroskop betrachtet werden, was von Vorteil ist, weil für die Maskenreparatur nicht zusätzlich ein kompliziertes teures Gerät entwickelt oder angeschafft werden muss. Im Elektronenrastermikroskop herrscht ein Vakuum, das keineswegs als rein bezeichnet werden kann und einen Gesamtdruck im Bereich von etwa 0,133 bis 0,0133 µbar aufweist. Bei dem erfindungsgemässen Reparaturverfahren wird ausgenutzt, dass die im Vakuum befindlichen Kohlenwasserstoffmoleküle, die aus dem Diffusionspumpenöl stammen, unter Einwirkung des Elektronenstrahls polymerisieren. Richtet man nämlich einen fein fokussierten Elektronenstrahl oder Ionenstrahl auf den Rand einer zu schliessenden oder korrigierenden Maskenöffnung und lässt ihn langsam über die unerwünschte Maskenöffnung wandern, dann bildet sich ein selbsttragender Kontaminationsfaden, der dem Weg des Elektronenstrahls folgt. Schreibt man mehrere solcher Kontaminationsfäden 10 (Fig. 2E und Fig. 3) nebeneinander, so ist es möglich, das unerwünschte Maskenloch zu schliessen. Es wurde festgestellt, dass sehr gute Ergebnisse mit den Kohlenwasserstoffmolekülen, die als Restgase in einem normalen Mikroskopvakuum vorhanden sind, erzielt werden können. Es können jedoch auch andere Monomermoleküle, beispielsweise Butadien, Acetylen oder Acrylnitril dem Vakuum zugeführt und unter Einwirkung eines Elektronenstrahls zur Polymerisation gebracht werden.

In einem speziellen Ausführungsbeispiel wird eine zu reparierende Maske in ein Elektronenrastermikroskop eingebracht und der Elektronenstrahl direkt neben das zu reparierende Loch auf der Maskenoberfläche fokussiert. Wesentlich ist, dass der Strahldurchmesser sehr gering ist, damit sein Verhältnis zur umgebenden Oberfläche sehr klein ist. Es wurde mit Elektronenstrahldurchmessern im Bereich von 10 bis 100 nm gearbeitet. Im Elektronenrastermikroskop wurde eine Vergrösserung von 5000 bis 20 000 und eine sehr langsame Schreibgeschwindigkeit von etwa 1 bis 50 µm/Min. bei einem Vakuum im Bereich von etwa 0,0133 µbar gewählt. Die langsame Führung des Elektronenstrahls ist notwendig, damit genügend Moleküle zum Aufbau der Fäden nachdiffundieren können.

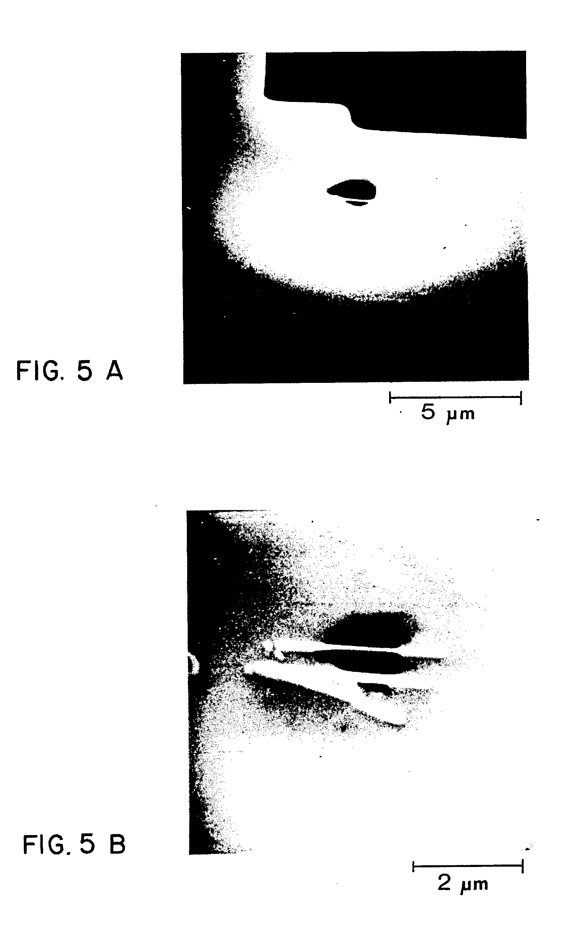

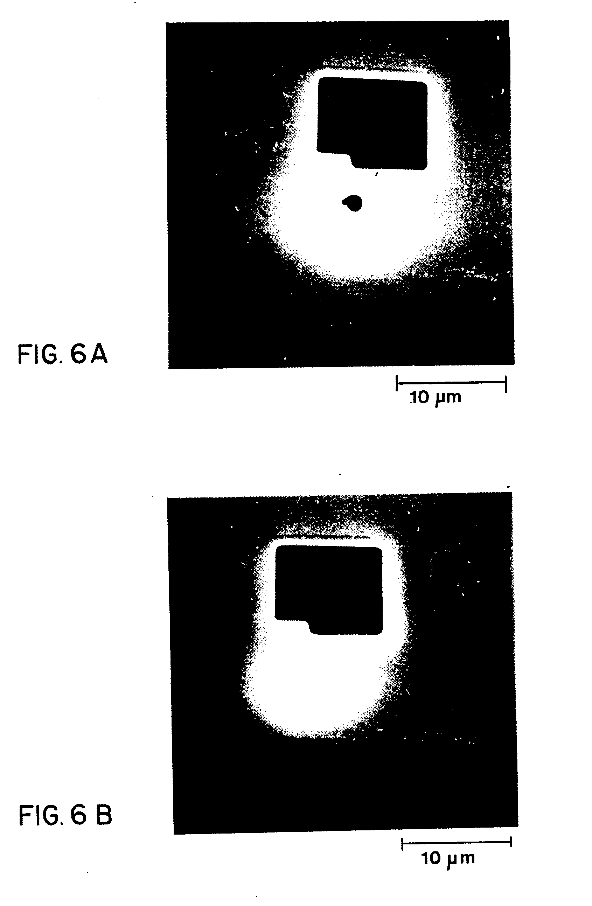

Fig. 3 zeigt ein zu schliessendes Loch mit zwei Stegen. In Fig. 4A ist ein zu schliessendes Loch neben einer gewünschten Maskenöffnung und in Fig. 4B das zu schliessende Loch bei 10facher Vergrösserung dargestellt. In den Fign. 5A und B sind bereits mehrere Kontaminationsfäden über das zu schliessende Loch gelegt. Fig. 6A entspricht Fig. 4A und zeigt noch einmal den Ausgangszustand, während in Fig. 6B nur noch die erwünschte Maskenöffnung zu sehen ist und die unerwünschte geschlossen ist.

Die Reparatur einer unerwünschten Maskenöffnung kann ausser in dem Elektronenrastermikroskop auch mit einem Elektronenstrahlschreiber (vector scan) erfolgen. Hier werden entweder über das Loch Kontaminationsfäden geschrieben, oder der Elektronenstrahl wird am Lochrand entlang geführt und so ein Zuwachsen des Lochs erreicht. Dieses Verfahren hat den Vorteil, dass vor der Reparatur eine Inspektion der Maske im gleichen Gerät vorgenommen werden kann. Die Inspektion der Maske geschieht durch einen Vergleich des vom Elektronenstrahl gefundenen Maskenlochs mit den im Computer vorhandenen Daten der Maskenstruktur. Wird auf diese Weise festgestellt, dass es sich um ein unerwünschtes Maskenloch handelt, dann kann die Maske, ohne dass sie aus dem Gerät entnommen werden muss, an der entsprechenden Stelle gezielt repariert werden. Hierbei wird in einem vergleichbaren Vakuum wie im Elektronenrastermikroskop und mit einem Elektronenstrahl mit einem Durchmesser von 10 bis 100 nm gearbeitet.

Sollten bei beiden Verfahren die aus dem Diffusionspumpenöl stammenden Kohlenwasserstoffmoleküle für die Maskenreparatur nicht ausreichen, dann kann in der Nähe des Maskenhalters zusätzlich ein Tropfen Öl angeordnet werden, oder es kann in der Umgebung der Maske eine ölhaltige Atmosphäre dadurch erzeugt werden, dass Monomermoleküle über ein Nadelventil oder ein Kapillarröhrchen zugeführt werden. Ausser den Kohlenwasserstoffmonomeren können auch, wie zuvor bereits ausgeführt, andere Monomermoleküle zugeführt werden.

Die schematische Darstellung gemäss Fig. 2E zeigt Fäden 10 aus Polymermaterial, die über ein ausgefranstes Maskenloch 9b bzw. über eine unerwünschte Maskenöffnung 9c geschrieben wurden. Das unerwünschte Maskenloch 9c wird, nachdem es auf der Oberseite verschlossen wurde, von der Rückseite her mit einem leitenden Material 11, beispielsweise einem Metall, ausgefüllt. Hierzu kann Gold verwendet werden, welches anschliessend, wie aus Fig. 2F ersichtlich ist, auch auf die Vorder- und Rückseite der reparierten Siliciummaske zu einer Schicht 12 aufgesputtert oder aufgedampft wird. Die Kontaminationsfäden 10, welche zur Reparatur der fehlerhaften Maske verwendet wurden, können vor dem Aufdampfen der Goldschicht 12 von der Maske entfernt werden.

## Patentansprüche

1. Verfahren zur Reparatur von Transmissionsmasken unter Anwendung von Kontaminationspolymerisation, dadurch gekennzeichnet, dass man einen fein fokussierten Elektronenstrahl in einem Vakuumsystem zeilenweise über eine unerwünschte Maskenöffnung oder am Rand einer Maskenöffnung entlang führt, um die Öffnung durch die dem Strahl folgenden Kontaminationsstreifen vollständig zu schliessen oder die Form der Maskenöffnung zu korrigieren, dass die reparierte Maskenöffnung von der Rückseite der Maske her mit einem leitenden Material aufgefüllt und das mit dem Elektronenstrahl aufgetragene Polymergerüst entfernt wird und auf Vorder- und Rückseite der Maske eine Goldschicht aufgedampft oder aufgesputtert wird.

2. Verfahren nach Anspruch 1, dadurch gekennzeichnet, dass die Maskenreparatur in einem Elektronenrastermikroskop oder mit einem Elektronenstrahlschreiber (vector scan) durchgeführt wird.

3. Verfahren nach den Ansprüchen 1 und 2, dadurch gekennzeichnet, dass die Maskenreparatur in einem Vakuum im Bereich von 0,133 bis 0,0133 μbar durchgeführt wird.

4. Verfahren nach den Ansprüchen 1 und 2, dadurch gekennzeichnet, dass die Maskenreparatur mit einem Elektronenstrahl mit einem Strahldurchmesser im Bereich von 10 bis 100 nm durchgeführt wird.

5. Verfahren nach den Ansprüchen 1 bis 4, dadurch gekennzeichnet, dass man den Elektronenstrahl mit einer Schreibgeschwindigkeit von 1 bis 50 μm/Min. über die unerwünschte Maskenöffnung führt.

6. Verfahren nach den Ansprüchen 1 bis 5, dadurch gekennzeichnet, dass man in der Umgebung der Maske eine Monomermolekülhaltige Atmosphäre erzeugt.

7. Verfahren nach Anspruch 6, dadurch gekennzeichnet, dass Monomere aus der Gruppe von Kohlenwasserstoffmolekülen, Butadien, Acetylen oder Acrylnitril eingesetzt werden.

8. Verfahren nach den Ansprüchen 6 und 7, dadurch gekennzeichnet, dass die Monomermoleküle über ein Nadelventil oder ein Kapillarröhrchen in der Umgebung der Maske zudosiert werden oder in Form eines Tropfens auf den Maskenrand zugegeben werden.

9. Verfahren nach Anspruch 6, dadurch gekennzeichnet, dass Kohlenwasserstoffmoleküle, die aus dem Diffusionspumpenöl stammen und im Restvakuum vorhanden sind, durch den Elektronenstrahl polymerisiert werden.

## Claims

1. Method of repairing transmission masks using contamination polymerisation, characterized in that in a vacuum system a precisely focused electron beam is moved line by line over an undesired mask opening, or along the edge of the mask opening in order to close the opening completely by the contamination filament following the beam, or to correct the form of the mask opening, and in that the repaired mask opening is replenished from the mask back with a conductive material, that the polymeric structure applied with the electron beam is removed, and a gold layer is vapor deposited or sputtered onto the front and back of the mask.

2. Method as claimed in claim 1, characterized in that the mask is repaired in an electron scanning microscope or with a vector scan.

3. Method as claimed in claims 1 and 2, characterized in that the mask is repaired in a vacuum in the range of 0.133 to 0.0133 μbar.

4. Method as claimed in claims 1 and 2, characterized in that the mask is repaired with an electron beam, with a beam diameter ranging from 10 to 100 nm.

5. Method as claimed in any one of claims 1 to 4, characterized in that the electron beam is moved with a writing speed of 1 to 50 μm/min. over the undesired mask opening.

6. Method as claimed in any one of claims 1 to 5, characterized in that a monomer molecule-containing atmosphere is generated in the mask surroundings.

7. Method as claimed in claim 6, characterized in that monomers selected from the group consisting of hydrocarbon molecules, butadiene, acetylene or acrylonitrile are used.

8. Method as claimed in claims 6 and 7, characterized in that the monomer molecules are metered via a needle valve or a capillary tube to the mask surroundings, or added in the form of a droplet onto the mask edge.

9. Method as claimed in claim 6, characterized in that hydrocarbon molecules originating from the diffusion pump oil and remaining in the residual vacuum are polymerized by the electron beam.

**Revendications**

1. Procédé pour la réparation de masques de transmission avec utilisation de polymérisation de contamination, caractérisé en ce que, dans un système sous vide, on dirige en lignes un faisceau d'électrons finement focalisé sur une ouverture indésirable d'un masque ou le long du bord d'une ouverture d'un masque, afin d'obturer complètement l'ouverture ou de corriger la forme de l'ouverture du masque au moyen des bandes de contamination suivant le faisceau, on remplit avec un matériau conducteur l'ouverture réparée du masque, par le dos du masque, puis on élimine le squelette polymère appliqué au moyen du faisceau d'électrons, et on dépose par pulvérisation ou vaporisation une couche d'or sur la face supérieure et au dos du masque.

2. Procédé selon la revendication 1, caractérisé en ce que l'on effectue la réparation du masque dans un microscope électronique à balayage ou au moyen d'un traceur à faisceau d'électrons (vector scan).

3. Procédé selon les revendications 1 et 2, caractérisé en ce que l'on effectue la réparation du masque dans un vide dans la plage de 0,133 à 0,0133 μbar.

4. Procédé selon les revendications 1 et 2, caractérisé en ce que l'on effectue la réparation du masque au moyen d'un faisceau d'électrons ayant un diamètre de faisceau dans la plage de 10 à 100 nm.

5. Procédé selon les revendications 1 à 4, caractérisé en ce que l'on dirige sur l'ouverture indésirable du masque le faisceau d'électrons à une vitesse de tracé de 1 à 50 μm/min.

6. Procédé selon les revendications 1 à 5, caractérisé en ce que l'on engendre dans l'environnement du masque une atmosphère contenant des molécules de monomères.

7. Procédé selon la revendication 6, caractérisé en ce que l'on utilise des monomères choisis parmi des molécules d'hydrocarbures, le butadiène, l'acétylène ou l'acrylonitrile.

8. Procédé selon les revendications 6 et 7, caractérisé en ce que l'on introduit au voisinage du masque les molécules de monomères par une soupape à pointeau ou un tube capillaire, ou on les dépose sous forme d'une goutte sur le bord du masque.

9. Procédé selon la revendication 6, caractérisé en ce que les molécules d'hydrocarbure, qui proviennent de l'huile de la pompe à diffusion et sont présentes dans le vide résiduel, sont polymérisées sous l'effet du faisceau d'électrons.

SILICIUM

0,2 μm
BOR - DOTIERTES
Si

0,5 μm GOLD

FIG. 1

2 μm

FIG. 3

FIG.2A

FIG.2B

FIG.2C

FIG.2D

FIG.2E

FIG.2F

FIG. 4 A

10 μm

FIG. 4 B

1 μm

FIG. 5 A

5 μm

FIG. 5 B

2 μm

FIG. 6 A

10 μm

FIG. 6 B

10 μm